# EUROPÄISCHE PATENTSCHRIFT

(11) **EP 0 706 218 B1**
(45) Veröffentlichungstag und Bekanntmachung des Hinweises auf die Patenterteilung: **13.11.2002**
(21) Anmeldenummer: 95810585.0
(22) Anmeldetag: 20.09.1995
(51) Int. Cl.: H01L 23/62

(54) **Verfahren zur Fehlerbehebung in einer Stromrichterschaltungsanordnung**
Method to eliminate errors in a rectifying circuit device
Procédé pour éliminer des erreurs dans un dispositif de ciruit rédresseur

(30) Priorität: 01.10.1994 DE 4435255
(43) Veröffentlichungstag der Anmeldung: 10.04.1996
(73) Patentinhaber: DaimlerChrysler Rail Systems GmbH, 13627 Berlin (DE)
(72) Erfinder: Etter, Peter, CH-5422 Oberehrendingen (CH)
(74) Vertreter: Thielmann, Andreas

(56) Entgegenhaltungen:
- EP-A- 0 554 195
- DE-A- 2 758 890
- DE-A- 3 532 383
- US-A- 4 819 157
- US-A- 5 123 746

## Beschreibung

### Technisches Gebiet

Die Erfindung bezieht sich auf das Gebiet der Leistungselektronik.

Sie betrifft ein Verfahren zur Fehlerbehebung in einer Stromrichterschaltungsanordnung mit Schaltern bestehend aus mehreren ein- und ausschaltbaren Schaltermodulen, welche jeweils mehrere, über Anschlussdrähte parallelgeschaltete Schalterchips umfassen, und einem mehrphasigen von einer Gleichspannungsquelle gespeisten Umrichter, wobei pro Phase zwei Schalter vorgesehen sind, von denen je einer zwischen dem Pluspol der Gleichspannungsquelle und einem Lastanschluss und der andere, zwischen dem Lustanschluss und dem Minuspol der Gleichspannungsquelle geschaltet ist.

### Stand der Technik

Aus dem Artikel "Moderne Leistungshalbleiter in der Stromrichtertechnik" von W. Bölsterling et al., etz Bd. 114 (1993) Heft 21, Seiten 1310-1319, sind Stromrichterschaltungsanordnungen bekannt, welche mehrere ein- und ausschaltbare Schaltermodule umfassen. Insbesondere handelt es sich dabei um IGBT-Module (IGBT = Insulated Gate Bipolar Transistor, Bipolartransistor mit isoliertem Gate) mit mehreren parallel geschalteten IGBT-Halbleiterchips pro Modul.

Die Gate-, Anoden und Kathodenanschlüsse der einzelnen Halbleiterchips werden normalerweise über Anschlussdrähte parallelgeschaltet und mit entsprechenden Leiterbahnen verbunden, welche die Modulanschlüsse bilden. Als Anschlussdrähte werden üblicherweise Bonddrähte verwendet.

IGBT-Module höherer Leistung bestehen praktisch immer aus einer grösseren Anzahl solcher parallelgeschalteter Halbleiterchips, um die geforderte Stromtragfähigkeit erreichen zu können. Die in einem mehrphasigen Stromrichter eingebauten IGBT-Module können durch Sperrversagen eines einzelnen Chips beschädigt werden. Das Halbleitersubstrat eines solchen Chips legiert durch und stellt anschliessend einen Kurzschluss dar. Um eine Beschädigung der gesamten Anlage zu vermeiden, sind Schutzeinrichtungen vorgesehen, die einen Kurzschluss eines Chips detektieren und den Stromrichter sofort abschalten. Ein Defekt eines einzelnen Chips legt also die gesamte Anlage lahm. Abgesehen von den Reparaturkosten können die sich daraus ergebenden Betriebsunterbrüche dem Anwender unter Umständen sehr teuer zu stehen kommen.

Die US-Patentschrift 5 123 746 offenbart ein Verfahren zur Fehlerbehebung in einer Stromrichterschaltungsanordnung mit Schaltern bestehend aus mehreren ein- und ausschaltbaren Schaltermodulen, welche jeweils mehrere, über Anschlussdrähte parallelgeschaltete Schalterchips umfassen. Den Schalterchips sind Sicherungen zugeordnet, wobei die Sicherungen derjenigen Schalterchips, die aufgrund eines Defekts einen Kurzschluss bilden, gezielt durchbrennen.

Aus der EP 0 554 195 A1 ist eine Schutzanordnung für monolithische Halbleiter bekannt, die mehrere parallelgeschaltete Halbleitermodule aufweisen, welche jeweils über eine Sicherung in Form eines schmelzfähigen Anschlussdrahtes an einer Elektrode angeschlossen sind. Im Falle eines Defekts eines der parallelgeschalteten Module wird der zugehörige Anschlussdraht gezielt durchtrennt.

Aus der DE 35 32 383 A1 ist ein Multizellentransistor bekannt, der aus einer Parallelschaltung einzelner Transistorenzellen zur Leistungsaufteilung besteht. Zur selbsttätigen Abtrennung defekter Transistorzellen sind Brennstrecken vorgesehen, die im Kurzschlussfall die defekte Transistorzelle aus dem Verbund trennen. Dabei ist zur Abtrennung einer Basisbrennstrecke ein spannungsgesteuerter Schalter vorgesehen.

### Darstellung der Erfindung

Aufgabe der vorliegenden Erfindung ist es, ein Verfahren zur Fehlerbehebung in einer Stromrichterschaltungsanordnung der eingangs genannten Art anzugeben, welches eine höhere Verfügbarkeit der Anlage ermöglicht und gewährleistet, dass beim Ausfall eines oder mehrerer Halbleiterschalterchips nicht die gesamte Anlage ausser Betrieb gesetzt wird. Diese Aufgabe wird durch die Merkmale des Anspruchs 1 gelöst.

Kern der Erfindung ist es also, dass die Anschlussdrähte derjenigen Schalterchips, welche einen allfälligen Defekt aufweisen und einen Kurzschluss bilden, gezielt durchgetrennt werden, wobei nachdem der Defekt festgestellt worden ist, in einem ersten Schritt alle Schaltermodule der Phasen ausgeschaltet werden.

Anschliessend wird das mit dem Pluspol der Gleichspannungsquelle verbundene Schaltermodul einer ersten Phase für eine bestimmte Zeitdauer tc eingeschaltet. Falls sich der Kurzschluss in einem Chip des mit dem Minuspol verbundenen Moduls derselben Phase befindet, so sorgt der durch dieses Modul fliessende Strom dafür, dass in der Zeitdauer tc die Anschlussdrähte des fehlerhaften Chips durchgetrennt werden. Denn dieser Chip muss die gesamte Stromlast tragen, da das Modul selber ausgeschaltet ist. Im allgemeinen werden dadurch die Anschlussdrähte durchgebrannt. Befindet sich der Kurzschluss aber im Modul, das mit dem Pluspol verbunden ist, so geschieht zunächst einmal gar nichts. Wird nun aber das mit dem Pluspol verbundene Modul wieder ausgeschaltet und das mit dem Minuspol verbundene für tc eingeschaltet, so werden die Anschlussdrähte eines defekten Chips in dem mit dem Pluspol verbundenen Modul durchgetrennt. Falls sich der Kurzschluss nicht in der ersten Phase befindet, wird mit den übrigen Phasen in derselben Weise verfahren bis der Fehler behoben ist. Liegt ein nicht behebbarer Fehler vor, so wird die Anlage ausser Betrieb genommen.

Bei einer Variante wird nach dem Erkennen des Fehlers und dem Ausschalten aller Module zunächst einmal die Gleichspannungsquelle ausgeschaltet bzw. entladen und anschliessend auf eine optimale Brennspannung hochgefahren. Mit dieser Brennspannung wird nun weitergefahren wie oben erläutert.

Weitere Ausführungsbeispiele ergeben sich aus den entsprechenden abhängigen Ansprüchen.

Der Vorteil des erfindungsgemässen Aufbaus besteht darin, dass durch ein Defekt eines oder mehrerer Chips nicht die gesamte Anlage ausser Betrieb gesetzt wird, sondern dass diese nach Ablauf des erfindungsgemässen Verfahrens weiter genutzt werden kann. Die Leistungsfähigkeit wird dabei nicht unbedingt reduziert, wenn dies bereits bei der Auslegung des Stromrichters berücksichtigt worden ist.

### Kurze Beschreibung der Zeichnungen

Nachfolgend wird die Erfindung anhand von Ausführungsbeispielen im Zusammenhang mit den Zeichnungen näher erläutert.

Es zeigen:
- **Fig. 1**: Eine Stromrichterschaltungsanordnung, für welche das Verfahren nach der Erfindung geeignet ist;
- **Fig. 2**: Das Schaltbild eines Schalters;
- **Fig. 3**: Das Schaltbild eines Schaltermoduls;
- **Fig. 4**: Einen Schnitt durch ein Schaltermodul, das speziell für das Verfahren nach der Erfindung geeignet ist.

Die in den Zeichnungen verwendeten Bezugszeichen und deren Bedeutung sind in der Bezeichnungsliste zusammengefasst aufgelistet. Grundsätzlich sind in den Figuren gleiche Teile mit gleichen Bezugszeichen versehen.

### Wege zur Ausführung der Erfindung

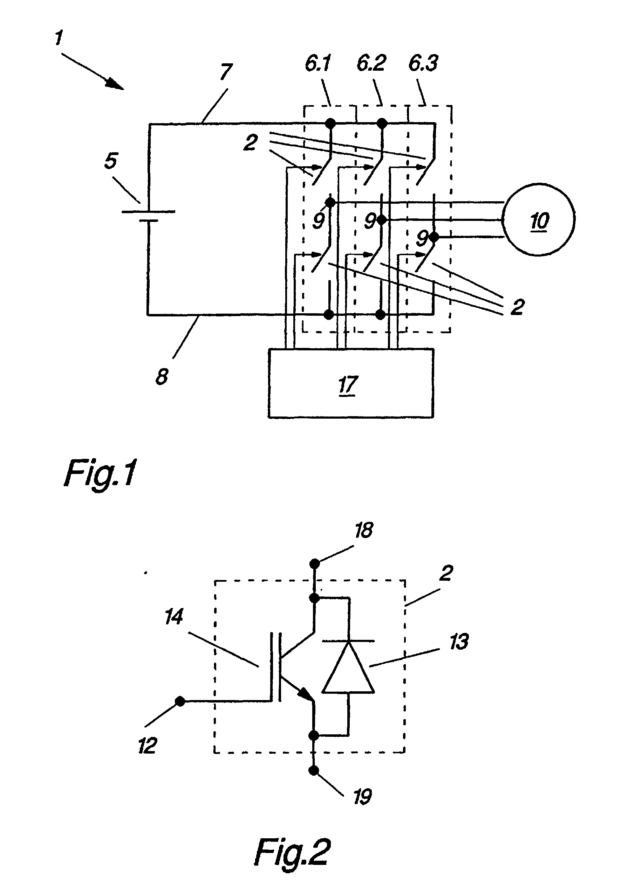

Figur 1 zeigt eine Stromrichterschaltungsanordnung 1, bei welcher das erfindungsgemässe Verfahren mit Vorteil angewendet wird. Es handelt sich dabei um einen 3-phasigen Umrichter, der von einer Gleichspannungsquelle 5 gespeist wird. Die Gleichspannungsquelle 5 kann beispielsweise eine Kondensatorbank eines Spannungszwischenkreises sein, die über einen Gleichrichter von einem Wechselspannungsnetz gespeist wird. Jede Phase 6.1-6.3 des Umrichters umfasst mindestens zwei Schalter 2. Die Schalter 2, von denen ein erster zwischen dem Pluspol 7 der Gleichspannungsguelle 5 und dem Lastanschluss 9 der Phase angeordnet ist und ein zweiter zwischen dem Lastanschluss 9 und dem Minuspol 8 der Gleichspannungsquelle 5, umfassen je mindestens ein steuerbares Schaltelement und eine dazu antiparallelgeschaltete Freilaufdiode 13. Das steuerbare Schaltelement umfasst beispielsweise ein Schaltermodul 14, es können jedoch auch mehrere Schaltermodule 14 pro Schalter 2 vorgesehen sein. Zur Erhöhung der Stromtragfähigkeit werden mehrere Module parallelgeschaltet, zur Erhöhung der Spannungsbelastbarkeit werden sie in Serie geschaltet. Die Lastanschlüsse 9 jeder Phase 6.1-6.3 sind mit einer Last verbunden, z.B. mit einem Motor 10. Eine Steuereinheit 17 schaltet nun die Module 2 jeder Phase abwechselnd ein- und aus, wobei die Phasen 6.1-6.3 untereinander phasenverschoben angesteuert werden, so dass an der Last eine mehrphasige Wechselspannung erzeugt wird, deren Frequenz eingestellt werden kann. Die Funktion eines derartigen Umrichters ist aus dem Stand der Technik hinlänglich bekannt und muss an dieser Stelle nicht weiter erläutert werden.

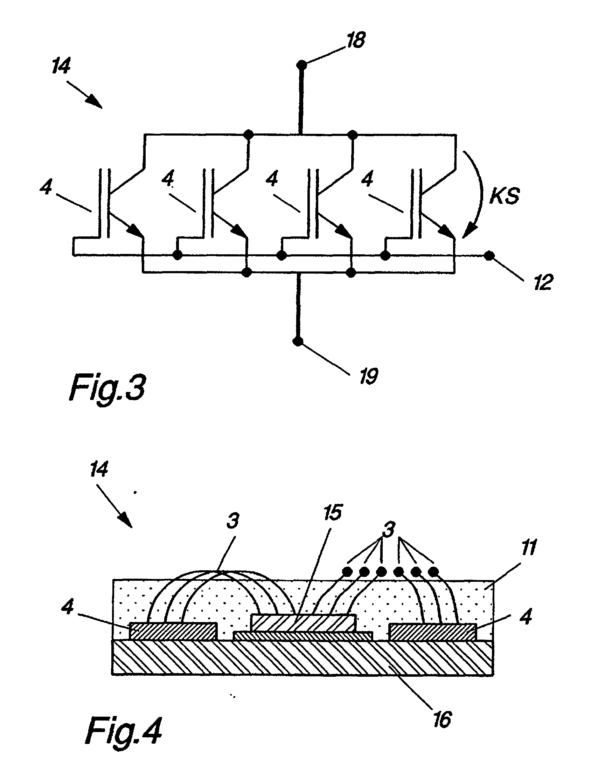

Figur 2 zeigt einen Schalter 2 im Detail. Er umfasst mindestens ein Schaltermodul 14 mit einer antiparallelgeschalteten Freilaufdiode 13. Der Schaltermodul 14 besteht vorzugsweise aus IGBT-Schaltelementen oder -Chips. Die Freilaufdiode 13 kann auch im Modul 14 integriert sein oder als diskretes Bauelement antiparallel zum Schaltermodul 14 geschaltet sein. Das Modul 14 selbst umfasst einen Gateanschluss 12, eine Anode 18 und eine Kathode 19. Für Hochleistungsanwendungen ist das Modul 14 seinerseits aus einer Parallelschaltung von Halbleiterchips 4 zusammengesetzt. Beim dargestellten Ausführungsbeispiel also aus IGBT-Chips. Dies zeigt Figur 3.

Wie Figur 4, die Darstellung eines Schaltermoduls 14 im Schnitt, zeigt, sind die Chips 4 über Anschlussdrähte 3 z.B. mit Leiterbahnen 15 verbunden. Es handelt sich dabei im allgemeinen um sog. Bonddrähte. Legiert nun ein Chip 4 durch, so wird das gesamte Modul 14 kurzgeschlossen. Der Kurzschlussstrom ist gegebenenfalls sehr gross und könnte das Modul 14 zerstören. Deshalb ist eine Schutzschaltung vorgesehen, welche den Fehler detektiert und die übrigen Zweige des Stromrichters sofort abschaltet, um sie vor Beschädigung zu schützen.

Die Steuereinheit 17 einer realisierten Stromrichterschaltungsanordnung 1 erzeugt ein geregeltes Zündimpulsmuster zur Ansteuerung der Schaltermodule 14. Dieses Zündimpulsmuster wird z.B. in optische Signale umgewandelt und über Glasfasern den Modulen 14 zugeleitet. Eine optische Übertragung wird aus EMV-Gründen und wegen der Potentialtrennung bevorzugt. Die optischen Signale werden entweder sogenannten Gate-Units, welche die optischen Signale wieder in elektrische umwandeln, oder direkt den Modulen zugeführt. Im letzteren Fall müssen die Module 14 einen entsprechenden Wandler bereits integriert haben. Dies ist mit den heute erhältlichen intelligenten Leistungsmodulen (IPM = Intelligent Power Module) kein Problem mehr. Die Signalverbindung zwischen der Steuereinheit und den Modulen ist bidirektional, so dass es möglich ist, Informationen über den Zustand der Gate-Unit bzw. der Module an die Steuereinheit zurückzumelden.

Wird erkannt, dass ein Modul defekt ist, so schaltet die Steuereinheit bei den bekannten Verfahren die gesamte Anlage aus, um sie vor mechanischer Beschädigung zu schützen. Auf diese Weise wird verhindert, dass sich der Fehler eines Moduls ausweitet und die ganze Anlage beschädigt wird. Es ist besonders wichtig, dass im Falle eines Fehlers beide Module einer Phase gesperrt werden. Falls dies nicht gelänge, müsste gegebenenfalls eine Explosion der Module erwartet werden, da das resultierende Kurzschlussstrom-Zeitintegral im allgemeinen viel höher ist als die entsprechenden zulässigen Werte der Module. Bei einem erfolgreichen Schutzeingriff obiger Art wird zwar ein Folgefehler vermieden, allerdings besteht dann ein dauernder Kurzschluss, so dass die Anlage nicht wieder eingeschaltet werden kann, bevor das entsprechende Module ausgewechselt worden ist.

Mit dem Fehlerbehebungsverfahren nach der Erfindung werden solche, u.U. sehr kostspielige Unterbrüche vermieden. Dies erreicht man kurz gesagt dadurch, dass die Anschlussdrähte eines defekten Moduls durchgetrennt werden. Zu diesem Zweck werden in einem ersten Schritt alle Schaltermodule 14 jeder Phase 6.1-6.3 ausgeschaltet. Anschliessend wird z.B. das mit dem Pluspol 7 der Gleichspannungsquelle 5 verbundene Modul 14 z.B. der Phase 6.1 eingeschaltet. Falls der Kurzschluss in dem mit dem Minuspol 8 verbundenen Modul 14 derselben Phase liegt, so fliesst der gesamte Strom über die Anschlussdrähte 3 des defekten Chips, denn das betreffende Modul ist ja ausgeschaltet. Man lässt nun den Strom nur für eine Zeitdauer (Brennzeit) tc fliessen, so dass die Anschlussdrähte 3 durchgetrennt werden. Dadurch wird der defekte Chip 4 vom Rest des Moduls elektrisch abgetrennt und das entsprechende Modul 14 ist wieder einsatzfähig. Gegebenenfalls wird dadurch zwar die Leistungsfähigkeit des Moduls herabgesetzt, doch kann dies durch entsprechende Auslegung, bei der ein Teil der Chips als redundanter Anteil vorgesehen wird, ausgeglichen werden.

Befindet sich der Kurzschluss jedoch nicht in dem mit dem Minuspol 7 verbundenen Modul 14 der Phase 6.1, so geschieht überhaupt nichts, da der Stromkreis ja offen ist. In diesem Fall wird das mit dem Pluspol 7 verbundene Modul 14 wieder ausgeschaltet und dafür das mit dem Minuspol 8 verbundene Modul 14 für eine Zeitdauer tc eingeschaltet. Analog wie oben werden, falls dieses Modul einen Kurzschluss aufweist, die Anschlussdrähte durchgetrennt.

Befindet sich das defekte Modul nicht in der Phase 6.1, so wird mit den übrigen Phasen 6.2-6.3 entsprechend verfahren bis der Fehler behoben ist.

Bei der Verwendung von intelligenten Leistungsmodulen, welche einen Fehler selbsttätig an die Steuereinheit übermitteln können, kann das Verfahren nach der Erfindung direkt und gezielt am defekten Modul angewendet werden. Die ermöglicht eine weitere Verkürzung des Betriebsunterbruchs.

Wenn die Anschlussdrähte 3 als Sicherung ausgelegt sind, wird mit Vorteil direkt die Zwischenkreisspannung zum Auftrennen der Anschlussdrähte eines defekten Moduls appliziert. Wenn die Anschlussdrähte 3, im allgemeinen Bonddrähte, jedoch nicht als Hochspannungssicherung ausgelegt sind, ist deren Lichtbogenspannung klein (kleiner als 1000 V). Aus diesem Grund ist es weiter von Vorteil, wenn die während der Zeitdauer tc applizierte Brennspannung möglichst tief ist. Andernfalls reicht die Lichtbogenspannung nicht, um den Strom auszuschalten und die Gefahr besteht, dass der Fehlerstelle zu viel Energie zugeführt wird. Dadurch würden nicht nur die Anschlussdrähte 3 durchgetrennt, sondern noch weitere Beschädigungen verursacht.

Dieses Problem kann nun dadurch verhindert werden, dass die Gleichspannungsquelle 5 bzw. die Zwischenkreiskondensatorbank nach dem Abschalten aller Module 14 zunächst entladen und anschliessend auf eine optimale Brennspannung aufgeladen wird und das Verfahren nach der Erfindung mit dieser Brennspannung fortgesetzt wird. Die optimale Brennspannung kann aus den Materialeigenschaften der Anschlussdrähte 3 und der Zeitdauer tc berechnet werden.

Die Zeitdauer tc und damit die Länge des angelegten Strompulses sowie dessen Höhe (Brennspannung) wird so festgelegt, dass eine Struktur der unterbrochenen Stelle entsteht, welche in der Lage ist, die an dieser Stelle nach Wiederaufnahme des Normalbetriebes anliegende Betriebsspannung dauerhaft zu sperren.

Eine weitere Massnahme zur Verhinderung von unkontrollierbaren Beschädigungen beim Durchtrennen der Anschlussdrähte 3 besteht darin, dass die Anschlussdrähte 3 mit einem Vergussmittel 11 umgeben werden. Wie Figur 4 zeigt, ragen die Anschlussdrähte 3 in diesem Fall ein Stück über das Vergussmittel 11. An dieser Stelle werden die Anschlussdrähte 3 durchgetrennt. Das Vergussmittel 11 verhindert dabei ein weiteres Abschmelzen der Drähte 3 und damit ein unkontrolliertes Ausbreiten der applizierten Brennenergie auf das Modul 14. Als Vergussmittel 11 kann beispielsweise Silicon-Gel verwendet werden.

Figur 4 zeigt den Aufbau eines Schaltermoduls 14 im Schnitt. Auf einer Grundplatte 16 ist eine Anzahl Schalterchips 4 aufgebracht, z.B. aufgelötet. Ausserdem sind Leiterbahnen 15 vorgesehen, welche die Anschlüsse der Module 14 bilden. In der Figur ist der Einfachheit halber nur die Kontaktierung einer Seit, z.B. der Kathodenseite, dargestellt. Die Elektroden der Chips 4 werden über Anschlussdrähte 3, i.a. Bonddrähte mit den Leiterbahnen 15 verbunden. Vorzugsweise werden IGBT-Chips 4 verwendet. Diese weisen drei Hauptelektroden, eine Anode 18, eine Kathode 19 und eine Gateelektrode 12 auf. Handelt es sich um ein intelligentes Leistungsmodul, so sind pro Modul 14 gegebenenfalls noch mehr Steuer- und Kontrollanschlüsse vorgesehen. Selbstverständlich können aber auch andere Halbleiterschalter verwendet werden, so z.B. MOS gesteuerte Thyristoren (MCT).

Optimale Werte für die Zeitdauer tc hängen natürlich von der angelegten Brennspannung ab. Im allgemeinen beträgt sie einige Mikrosekunden. Im Rahmen von Versuchen haben sich Werte zwischen ca. 20 µs und 10 ms bewährt. Besonders gute Ergebnisse wurden mit Werten zwischen 100 µs und 10 ms erreicht. Dies erlaubt, dass ca. alle 1 ms ein Modul mit der Brennspannung beaufschlagt werden kann. Bei einer dreiphasigen Anordnung ergeben sich also maximal 6 Durchgänge ä 1 ms. Dazu kommen noch zeitliche Verzögerungen für das Abschalten der Module und die Unterbrechung der Energiezufuhr sowie das Hochfahren der Zwischenkreisspannung. Insgesamt ergibt sich jedoch eine totale Fehlerbehebungszeit, welche im Bereich von Bruchteilen von Sekunden bis zu wenigen Sekunden liegt. Wird darüberhinaus auf die optimale Anpassung der Brennspannung verzichtet und die Anschlussdrähte mit der anlagebedingten Zwischenkreisspannung durchgetrennt, so dauert der ganze Fehlerbehebungsvorgang nur einige ms und ist deshalb kaum festzustellen.

Das Verfahren ist nicht auf die oben erläuterte Schaltungsanordnung beschränkt, sondern wird ganz allgemein bei allen Stromrichterschaltungsanordnung mit Modulen bestehend aus mehreren parallelgeschalteten Chips mit Vorteil eingesetzt.

Insgesamt steht also mit der Erfindung ein Verfahren zur Fehlerbehebung in einer Stromrichterschaltungsanordnung zur Verfügung, bei welchem allfällige Kurzschlüsse in den Halbleiterchips der Schaltermodule ohne Ausfall der gesamten Anlage behoben werden können.

### Bezeichnungsliste

- 1: Stromrichterschaltung
- 2: Schalter
- 3: Anschlussdrähte
- 4: Schalterchip
- 5: Gleichspannungsquelle
- 6.1-6.3: Phasen
- 7: Pluspol
- 8: Minuspol
- 9: Lastanschluss
- 10: Motor
- 11: Vergussmittel
- 12: Gateanschluss
- 13: Freilaufdiode
- 14: Schaltermodul
- 15: Leiterbahn
- 16: Grundplatte
- 17: Steuereinheit
- 18: Anode
- 19: Kathode
- KS: Kurzschluss

## Patentansprüche

1. Verfahren zur Fehlerbehebung in einer Stromrichterschaltungsanordnung (1) mit Schaltern (2) bestehend aus mehreren ein- und ausschaltbaren Schaltermodulen (14), welche jeweils mehrere, über Anschlussdrähte (3) parallelgeschaltete Schalterchips (4) umfassen, und einem mehrphasigen von einer Gleichspannungsquelle (5) gespeisten Umrichter, wobei pro Phase (6.1-6.3) zwei Schalter (2) vorgesehen sind, von denen je einer zwischen dem Pluspol (7) der Gleichspannungsquelle (5) und einem Lastanschluss (9) und der andere zwischen dem Lastanschluss (9) und dem Minuspol (8) der Gleichspannungsquelle (5) geschaltet ist,
**dadurch gekennzeichnet, dass** die Anschlussdrähte (3) derjenigen Schalterchips (4), die aufgrund eines allfälligen Defekts einen Kurzschluss bilden, gezielt durchgetrennt werden, indem nachdem der Defekt erkannt worden ist
a) in einem ersten Schritt alle Schaltermodule (14) jeder Phase (6.1-6.3) ausgeschaltet werden;
b) in einem zweiten Schritt das mit dem Pluspol (7) verbundene Schaltermodul (14) einer ersten Phase (z.B. 6.1) für eine Zeitdauer tc eingeschaltet wird und falls das mit dem Minuspol (8) verbundene Schaltermodul (14) nicht defekt war, anschließend das mit dem Minuspol (8) verbundene Schaltermodul (14) für die Zeitdauer tc eingeschaltet wird, nachdem das mit dem Pluspol (7) verbundene Schaltermodul (14) wieder ausgeschaltet wurde;
c) der zweite Schritt für die übrigen Phasen (z.B. 6.2, 6.3) wiederholt wird, falls das defekte Modul (14) nicht in der vorherigen Phase (6.1 bzw. 6.2) enthalten war.

2. Verfahren nach Anspruch 1, **dadurch gekennzeichnet, dass** die Gleichspannungsquelle (5) nach dem Ausschalten aller Schaltermodule (14) entladen wird und ananschliessend auf eine optimale Brennspannung aufgeladen wird.

3. Verfahren nach Anspruch 1 oder 2, **dadurch gekennzeichnet, dass** die Zeitdauer tc zwischen 100 µs und 10 ms liegt und die Brennspannung möglichst niedrig gewählt wird.

4. Verfahren nach einem der vorstehenden Ansprüche, **dadurch gekennzeichnet, dass** Schaltermodule (14) verwendet werden, deren Anschlussdrähte (3) mit einem Vergussmittel (11), insbesondere aus Silikon-Gel, umgeben werden, wobei die Anschlussdrähte (3) teilweise aus dem Vergussmittel (11) herausragen.

5. Verfahren nach einem der vorstehenden Ansprüche, **dadurch gekennzeichnet, dass** Schaltermodule (14) verwendet werden, deren Schalterchips (4) Transistoren mit isolierten Gate umfassen.

## Claims

1. A method for fault correction in a power converter circuit arrangement (1), having switches (2) and consisting of a plurality of switchmodules (14) which can be switched on and off and which respectively comprise a plurality of switch chips (4) connected in parallel via connecting wires (3), and a multi-phase converter fed from a DC voltage source (5), provision being made per phase (6.1 - 6.3) of two switches (2) of which one each is connected between the positive terminal (7) of the DC voltage source (5) and a load terminal (9), and the other is connected between the load terminal (9) and the negative terminal (8) of the DC voltage source (5),
**characterised in that** the connecting wires (3) of those switch chips (4) which create a short circuit due to a possible defect are severed selectively **in that** after the defect has been recognised
a) all the switch modules (14) of each phase (6.1 - 6.3) are switched off in a first step;
b) in a second step, the switch module (14), connected to the positive terminal (7), of a first phase (e.g. 6.1) is switched on for a period tc, and if the switch module (14) connected to the negative terminal (8) was not defective, the switch module (14) connected to the negative terminal (8) is then switched on for the period tc after the switch module (14) connected to the positive terminal (7) has been switched off again;
c) the second step for the remaining phases (e.g. 6.2, 6.3) is repeated if the defective module (14) was not included in the previous phase (6.1 or 6.2).

2. The method as claimed in Claim 1, **characterised in that** the DC voltage source (5) is discharged after the switching off of all the switch modules (14) and subsequently charged to an optimum voltage drop.

3. The method as claimed in Claim 1 or 2, **characterised in that** the period tc is between 100 µs and 10 ms and the voltage drop is selected to be as low as possible.

4. The method as claimed in any one of the foregoing claims, **characterised in that** switch modules (14) are used whose connecting wires (3) are surrounded by an encapsulant (11), in particular made from silicon gel, whereby the connecting wires (3) partially project from the encapsulant (11).

5. The method as claimed in any one of the foregoing claims, **characterised in that** switch modules (14) are used whose switch chips (4) comprise transistors having insulated gates.

## Revendications

1. Procédé pour éliminer les erreurs dans une disposition de circuitsredresseurs (1) avec des commutateurs (2) constitués de plusieurs modules de commutation (14) pouvant être enclenchés et coupés, lesquels comprennent respectivement plusieurs puces de commutation (4) montées en parallèle sur des fils de raccordement (3), et d'un survolteur polyphasé alimenté par une source de tension continue (5), deux commutateurs (2) étant prévus par phase (6.1-6.3), parmi lesquels respectivement l'un est monté entre le pôle positif (7) de la source de tension continue (5) et une prise de charge (9) et l'autre entre la prise de charge (9) et le pôle négatif (8) de la source de tension continue (5),
**caractérisé en ce que** les fils de raccordement (3) de chaque puce de commutation (4), qui forment un court-circuit du fait de toute panne aléatoire, sont sectionnés précisément, dans lequel, après reconnaissance de lapanne,
a) tous les modules de commutation (14) de chaque phase (6.1-6.3) sont coupés dans une première étape;
b) dans une deuxième étape, le module de commutation (14) d'une première phase (par exemple, 6.1), relié au pôle positif (7) est enclenché pendant une durée tc et si le module de commutation(14) relié au pôle négatif (8) n'était pas défectueux, le module de commutation(14) relié au pôle négatif (8) est enclenché ensuite pendant la durée tc, après une nouvelle coupure du module de commutation (14) relié au pôle positif (7) ;
c) la deuxième étape pour les autres phases (par exemple, 6.2, 6.3) est répétée, si le module défectueux (14) n'était pas inclus dans la phase précédente (6.1 ou 6.2).

2. Procédé selon la revendication 1, **caractérisé en ce que** la source de tension continue (5) est déchargée après coupure de tous les modules de commutation (14) et chargée ensuite à une tension optimale de décharge.

3. Procédé selon la revendication 1 ou 2, **caractérisé en ce que** la durée tc est comprise entre 100 µs et 10 ms et que l'on choisit la tension de décharge la plus faible possible.

4. Procédé selon l'une quelconque des revendications précédentes, **caractérisé en ce que** des modules de commutation (14) sont employés, dont les fils de raccordement (3) sont entourés par un agent d'enrobage (11), en particulier en gel de silicone, les fils de raccordement (3) se projetant partiellement à partir de l'agent d'enrobage (11).

5. Procédé selon l'une quelconque des revendications précédentes, **caractérisé en ce que** des modules de commuation (14) sont employés, dont les puces de commutation (4) comprennent des transistors avec une grille isolée.
